# EUROPEAN PATENT SPECIFICATION

(11) **EP 4 222 765 B1**
(45) Date of publication and mention of the grant of the patent: **08.04.2026**
(21) Application number: 21787129.2
(22) Date of filing: 09.09.2021
(51) Int. Cl.: H01G 4/10, H01G 4/20, H01G 4/224, G01R 15/06, G01R 15/16, H01G 4/18

(54) **DIELECTRIC MATERIAL FOR A HIGH VOLTAGE CAPACITOR**
DIELEKTRISCHES MATERIAL FÜR HOCHSPANNUNGSKONDENSATOR
MATÉRIAU DIÉLECTRIQUE POUR CONDENSATEUR HAUTE TENSION

(30) Priority: 01.10.2020 US 202063086318 P; 28.05.2021 US 202163202174 P
(43) Date of publication of application: 09.08.2023
(73) Proprietor: 3M Innovative Properties Company, St. Paul, MN 55133-3427 (US)
(72) Inventor: STOLLWERCK, Gunther, A., J., 41453 Neuss (DE); GHOSH, Dipankar, Saint Paul, MN 55133-3427 (US); SHAABAN, Ahmad, 41453 Neuss (DE)
(74) Representative: Mathys & Squire
(86) International application number: PCT/US2021/049650
(87) International publication number: WO 2022/072130

(56) References cited:
- WO-A1-2018/211358
- WO-A1-2020/016687
- CN-B- 107 705 985
- US-A- 6 031 368
- US-A1- 2007 087 929
- US-A1- 2017 174 838
- KOVACEVIC UROS D ET AL: "Design of capacitive voltage divider for measuring ultrafast voltages", INTERNATIONAL JOURNAL OF ELECTRICAL POWER & ENERGY SYSTEMS, JORDAN HILL, OXFORD, GB, vol. 99, 20 February 2018 (2018-02-20), pages 426 - 433, XP085366214, ISSN: 0142-0615, DOI: 10.1016/J.IJEPES.2018.01.030

## Description

### BACKGROUND OF THE INVENTION

### Field of the Invention

The present invention relates to a high voltage capacitor having a low temperature coefficient of capacitance (TCC) and a small change in capacitance with temperature and in particular to the dielectric material for a high voltage capacitor.

### Background

As electrical power distribution becomes more complex through the advent of renewable energy, distributed generation, and the adoption of electric vehicles, intelligent electrical distribution and associated electrical sensing is becoming more useful and even necessary. Useful sensing may include voltage, current, and the time relationship between voltage and current at various locations within a power distribution network.

Traditionally, the power has been generated at a central location, and then distributed radially from the generation facility. As the development of the power grid matures, and more renewable energy is involved, the power flow in the distribution grid becomes less obvious, i.e., no longer simply flowing away from primary generation stations. Too, customers are becoming much more aware of power quality in regards voltage, harmonics, real/imaginary power magnitudes, etc.

Many existing relatively high voltage transformers and switchgears have a dedicated space for cable accessories, particularly in higher voltage applications (for example, 5 kV to 69 kV, or higher). Many of these transformers and switchgear are of a variety referred to in the power utility industry as dead-front. Dead-front means there are no exposed relatively high voltage surfaces in the connection between a power cable and the transformer or switchgear. Such cable accessory connections are sometimes referred to as elbows, T-bodies, or separable connectors. Such separable connectors have a front cavity to receive a protruding portion of the electrical equipment and a connection to high or medium voltage that can be mechanically and electrically connected to connection element, such as a bushing or a threaded stud, which is accessible through an opposed rear cavity of the separable connector. After installation on the electrical equipment, and insulating plug is placed in the rear cavity to insulate the connection element.

Elements of a voltage sensor for measuring the voltage of the connection element of a separable connector - and thereby the voltage of the power cable - can be integrated into the insulation plug, making it a "sensored insulation plug". A sensored insulation plug is described, for example, in the U.S. Patent No. 6,031,368.

The sensored insulation plug may include a capacitive voltage divider to accurately measure the voltage of the connection element. The voltage divider will typically include a high voltage portion and a low voltage portion and can be characterized by a dividing ratio that is constant with respect to time and temperature. The high voltage portion of such a voltage divider can be a plurality of individual capacitors connected in series or a single, low capacitance, high voltage capacitor comprising a dielectric material disposed between a pair of electrodes.

WO 2020/016687 A1 discloses a high voltage capacitor for a voltage divider that is configured to sense an elevated voltage for medium and high voltage electrical distribution networks, the high voltage capacitor comprising a high voltage electrode, a measurement electrode and a dielectric material disposed between the high voltage and measurement electrodes. US 2007/087929 A1 discloses a dielectric material for capacitors consisting in ceramic fillers disposed in an insulating polymer matrix, one of the fillers being strontium titanate.

A capacitor's capacitance is based on the spacing between and the geometry of the electrodes and the permittivity values of the dielectric material. The capacitance density of the dielectric materials can be increased by the addition of high permittivity dielectric filler materials at relatively high loadings. High loading of dielectric filler materials into the dielectric material often has a negative impact on mechanical properties, processing, stability of resulting capacitance with temperature. The change of capacitance as a function of temperature are described by the "temperature coefficient of capacitance" or TCC of the material. A material's TCC indicates the rate of change in capacitance as a function of temperature within a specified temperature range. Conventional dielectric composite capacitor materials have been developed which have a change in capacitance of from as low as ± 5% over the use temperature range of the capacitor. However, a need exists for capacitor materials having a very low change in capacitance in the range of from about ± 0.5% over the use temperature range of a high voltage capacitor that has a capacity of more than 10 pF.

### SUMMARY

A high voltage capacitor for a voltage divider according to the invention is defined by the features of either claim 1 or independent claim 3, a sensor according to the invention is defined by the features of independent claim 11, a voltage sensing device according to the invention is defined by the features of independent claim 13, a cable accessory according to the invention is defined by the features of independent claim 14. Further embodiments are defined by the appended claims.

### BRIEF DESCRIPTION OF THE DRAWINGS

Fig. 1A is a schematic cross-section of a first sensored insulation plug having an exemplary primary capacitor according to an aspect of the invention.
Fig. 1B is a cross section of a second sensored insulation plug having an exemplary primary capacitor according to an aspect of the invention.
Fig. 2 is a schematic drawing of a separable connector and an exemplary sensored insulation plug according to an aspect of the invention.
Figure 3 is a graph showing the change in capacitance with temperature of the dielectric materials of Examples EX. 1 - EX. 3.

### DETAILED DESCRIPTION OF THE EMBODIMENTS

In the following detailed description, reference is made to the accompanying drawings, which form a part hereof, and in which is shown by way of illustration specific embodiments in which the invention can be practiced. In this regard, directional terminology, such as "top," "bottom," "front," "back," "forward," etc., is used with reference to the orientation of the Figure(s) being described. Because components of embodiments of the present invention can be positioned in a number of different orientations, the directional terminology is used for purposes of illustration and is in no way limiting. It is to be understood that other embodiments can utilize structural or logical changes without departing from the scope of the present invention. The following detailed description, therefore, is not to be taken in a limiting sense, and the scope of the present invention is defined by the appended claims.

The present disclosure describes a high voltage, low capacitance capacitor for use in a sensored insulation plug as a component of a voltage sensor, such as, for example, a primary capacitor or a high voltage portion of a voltage divider of a voltage sensor. The component, for example the primary capacitor, may be embedded (partially or completely) in a plug body of the sensored insulation plug. In particular, a sensored insulation plug may be an insulation plug comprising a high voltage capacitor of a voltage-dividing voltage sensor for sensing an elevated voltage.

The present disclosure relates to voltage sensing devices for use in medium-voltage (MV) or high voltage (HV) power distribution networks in which electrical power is distributed via HV/MV power cables, transformers, switchgears, substations etc. with currents of tens or hundreds of amperes and voltages of tens of kilovolts. The term "medium voltage" or "MV" as used herein refers to AC voltages in the range of 1 kV to 72 kV, whereas the term "high voltage" or "HV" refers to AC voltages of more than 72 kV. Medium voltage and high voltage are collectively referred to herein as "elevated voltage".

A sensored insulation plug may include a capacitive voltage divider to accurately measure the voltage of the connection element. The voltage divider will typically include a high voltage portion and a low voltage portion and can be characterized by a dividing ratio that is constant with respect to temperature and time. The high voltage portion of such a voltage divider can be a plurality of individual capacitors connected in series or a single, high voltage capacitor. The high voltage portion of the voltage divider is the portion that is electrically arranged between a signal contact, at which a divided voltage can be picked up, and the elevated voltage which is to be sensed. The low-voltage portion of the voltage divider is the portion that is electrically arranged between that signal contact and electrical ground.

In an exemplary aspect, the high voltage portion will comprise a single, high voltage capacitor or primary capacitor that comprises a dielectric material disposed between a pair of electrodes. The dielectric material comprises first and second dielectric fillers disposed in an insulating polymer matrix such that the capacitance of the dielectric does not vary by more than +/- 0.5% in the temperature range of -20°C to 60°C wherein the high voltage capacitor use with a line voltage of greater than 6 kV, 12 kV or 18 kV. The dielectric material comprises first and second dielectric fillers disposed in an insulating polymer matrix such that the capacitance of the dielectric does not vary by more than +/- 0.5% in the temperature range of -20°C to 60°C and the high voltage capacitor has a withstand voltage of at least 50 kV, preferably at least 70 kV and more preferably at least 85 kV.

The exemplary primary capacitor should have a voltage rating/operating voltage of at least 12 kV, preferably 18 kV for its expected lifetime (i.e. 30 years of sustained use). The term "withstand voltage" indicates the maximum voltage that can be resisted for an allotted time (e.g. 5 minutes) before breakdown. The term "breakdown voltage" is the minimum voltage at which a dielectric material is able to conduct electricity. European Committee for Electrotechnical Standardization (CENELEC) Standard HD 629.1 requires a breakdown strength of more than 85 kV for accessories used on power cables having a voltage rating of 18 kV.

In an exemplary embodiment, the dielectric material should have a temperature coefficient of capacitance (TCC) of +/- 125 ppm, preferably +/- 95 ppm, more preferably less than +/- 50 ppm.

The exemplary primary capacitor is used in a capacitive voltage divider that is electrically connected between the connection element on elevated voltage and electrical ground, for sensing the elevated voltage of the connection element of the separable connector. In an exemplary embodiment, a high voltage electrode of the primary capacitor is not only electrically, but also mechanically connected to the connection element of the separable connector. This mechanical connection is an electrically conductive connection. This mechanical connection may be a direct mechanical connection, i.e. a portion of the high voltage electrode is connected to the connection element without any intermediate element.

In some embodiments, this connection between the voltage divider and connection element of the separable connector may be an indirect mechanical connection, i.e. a portion of the high voltage electrode is connected to the connection element via an intermediate element, which is electrically conductive. The sensored insulation plug may thus further comprise an intermediate element which is operable to mechanically and electrically connect the high voltage electrode with the connection element. Such an intermediate element may be, for example, a contact piece. Such a contact piece may be connectable to the connection element of the separable connector via a conductive threaded stud that is threadedly connected to the connection element on one side and that can, on the other side, be threadedly engaged with the connection element of the sensored insulation plug.

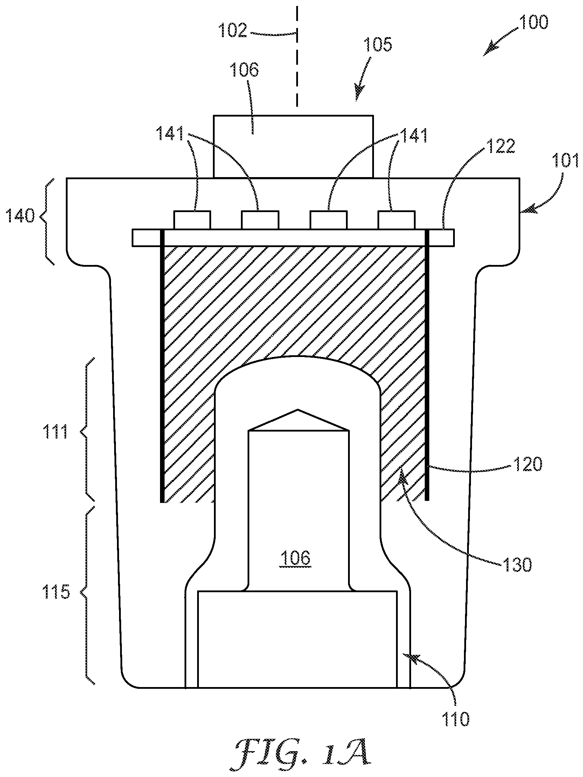

An exemplary primary capacitor is shown in Fig. 1A as part of an exemplary sensored insulation plug 100. The sensored insulation plug has a plug body 101 of an electrically insulating hardened resin a primary capacitor that comprises a high voltage electrode 110, a sensing or measurement electrode 120 and a dielectric material 130 disposed between the high voltage electrode and the measurement electrode.

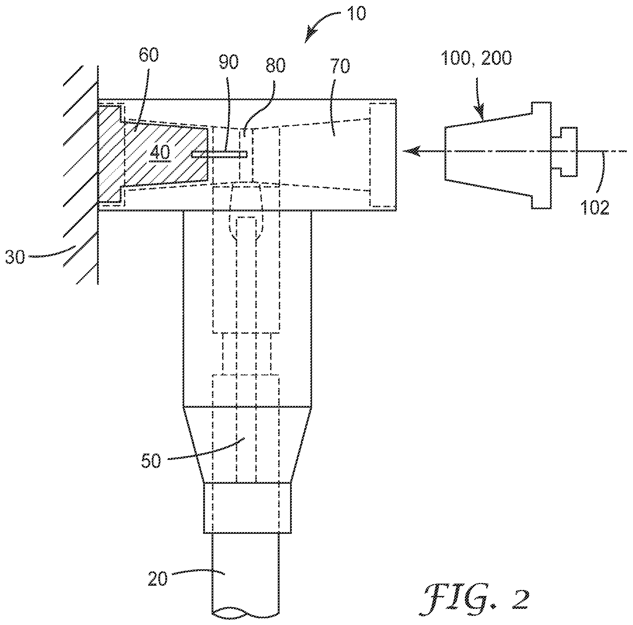

The high voltage electrode 110 has an electrode portion 111 and an engagement portion 115 for mechanical engagement and electrical connection with connection element 80 of the separable connector 10, shown in Fig. 2. High voltage electrode 110 is generally made of a conductive metal. The electrode portion 111 serves as the high voltage electrode 110 of the primary capacitor. In an exemplary aspect, the engagement portion 115 and the electrode portion 111 are formed as a single piece of metal. In an exemplary embodiment, the high voltage electrode 110 is rotationally symmetric about axis 102.

Engagement portion 115 has a threaded recess to mechanically and electrically engage connection element 80 of the separable connector 10. In use, engagement portion 115 and electrode portion 111 are on the elevated voltage of the connection element 80 of the separable connector 10.

The measurement electrode 120 has a generally hollow cylindrical shape such that the electrode portion 111 of the high voltage electrode 110 extends into the hollow interior of the measurement electrode such that the high voltage electrode and the measurement electrode are disposed in a concentric, spaced apart arrangement. In order to reduce the risk of electrical discharge between the measurement electrode and the high voltage electrode it is generally advisable to keep the electrodes at a distance from each other, because smaller distances are more likely to allow for discharges. The measurement electrode of the primary capacitor may be connected to, or formed with, other components, e.g. components for support or electrical or mechanical connection of the measurement electrode, to form a measurement electrode assembly. Within a measurement electrode assembly, the measurement electrode is the element that is arranged opposite to the high voltage electrode and that determines, in combination with the high voltage electrode, the capacitance of the primary capacitor.

The measurement electrode of the primary capacitor is embedded in the plug body, such that a portion of the measurement electrode or the entire measurement electrode is in surface contact with the insulating polymer material of the plug body 101.

The measurement electrode may be electrically connected, or connectable, to a low-voltage capacitor, such that the primary capacitor and the low-voltage capacitor form a voltage divider for sensing the elevated voltage of a connection element of a separable connector. In the exemplary embodiment shown in Fig. 1A, the measurement electrode 120 may be electrically connected to a printed circuit board 122 wherein the printed circuit board can comprise at least one low voltage capacitor 141of the low voltage portion of the voltage divider mounted thereon. In an alternative embodiment the low voltage portion of the voltage divider can be located external to plug body 101.

Dielectric material 130 is arranged between high voltage electrode 110 and measurement electrode 120. Having a dielectric material between the high voltage and measurement electrodes increases the capacitance of the primary capacitor, as compared to the case when air as the dielectric material and makes the capacitor suitable for use with high and medium voltages. More specifically the dielectric material is arranged between at least a portion of the measurement electrode and at least a portion of the high voltage electrode. In certain embodiments it is arranged between the measurement electrode and the high voltage electrode. In certain embodiments it is arranged between a portion of the measurement electrode and the high voltage electrode.

Because the measurement electrode and the high voltage electrode of the primary capacitor are on significantly different voltages, a strong electric field will exist between them. Advantageously the dielectric material is therefore a continuous material, i.e. free of voids, because air-filled voids in the dielectric material can increase the risk of partial discharge through these voids.

The dielectric material will have a continuous insulating polymer matrix and a first dielectric filler and a second dielectric filler dispersed in the insulating polymer matrix In some embodiments, the material for the polymer matrix should be a low viscosity liquid (e.g. less than 2000 mPas measured according to International Standard ISO 2555) prior to cure at the casting temperature and have a high glass transition temperature (e.g. greater than 100°C as measured dynamic scanning calorimetry) after being cured. Additionally, the exemplary material should have a low intrinsic TCC (e.g. less than +/- 125 ppm, preferably less than +/- 95 ppm, more preferably less than +/- 50 ppm), and a high voltage withstand rating (greater than 50 kV, preferably greater than 70 kV or more preferably greater than 85 kV as determined by CENELEC Standard HD 629.1). The insulating polymer matrix may comprise a curable epoxy resin, a curable polyurethane resin, a curable silicone resin or mixtures thereof.

Curable epoxy resins as described herein in comprise the base resin, the curative material that reacts with the base resin and a catalyst if required. Examples of suitable base resins for the curable epoxy resins include liquid resins comprising phenol novolak epoxies, epoxies having an aliphatic or aromatic hydrocarbon backbone derived from bisphenol A or bisphenol F, butadiene-acrylic modified epoxies, or combinations thereof. Exemplary epoxy materials for the insulating polymer matrix include EPIKOTE 807 epoxy resin available from Hexion, (Duisburg, Germany) and 3M^{™} Scotchcast^{™} Electrical Resin 250 available from 3M Company (St. Paul, MN, USA).

In an exemplary aspect, an anhydride curative may be selected to react with the epoxy resin. Exemplary anhydrides can be selected from for example: succinic anhydride, maleic anhydride, phthalic anhydride, hexahydrophthalic anhydride, methylhexahydrophthalic anhydride, trimellitic anhydride, hydrogenated trimellitic anhydride, 1,2-cyclopentanedicarboxylic anhydride, tetrahydrophthalique anhydride, methyl tetrahydrophthalic anhydride,5-norbornene-2,3-dimethyl hydrogenated 5-norbornene-2,3-dicarboxilic anhydride, methyl-5-norbornene-2,3-dicarboxylic anhydride, hydrogenated methyl-5-norbornene-2,3-dicarboxylic anhydride or combinations thereof. Either pure anhydride or acid anhydride can be used or mixtures of at least two of them. Exemplary commercially available products include Epikure 866, Epikure 854, Epikure 868 or Epikure 878 (all of which are available from Hexion).

In some embodiments, a tertiary amine-, quaternary ammonium-, tertiary phosphine-, imidazole-, and azabicyclo compound-curing accelerator may be used as a catalyst. An exemplary commercially available product is Epikure Catalyst 03932 (available from Hexion).

The insulating polymer matrix, which includes the epoxy resin, curative and catalyst, comprises from about 40 vol.% to about 70 vol.% based on the total volume of the dielectric material, preferably from about 45 vol.% to about 55 vol.%.

Useful dielectric fillers are, for example, silicon dioxide or silica (SiO₂), aluminum oxide or alumina (Al₂O₃), magnesium oxide (MgO), strontium titanate (SrTiO₃), barium zirconate (BaZrO₃) powder, barium titanate (BaTiO₃) or other electrically insulating inorganic materials. In an exemplary embodiment, the first dielectric filler is silicon dioxide and the second dielectric filler is strontium titanate. In an alternative exemplary embodiment, the first dielectric filler is aluminum oxide and the second dielectric filler is strontium titanate. In another embodiment, at least one of the first and second dielectric fillers can have its surface modified using a silane coupling agent or chemical surfactant to improve adhesion with the polymer matrix material. Alternatively, a dispersing agent can be used.

In an exemplary embodiment, the second filler may be an essentially pure SrTiO₃ powder, having minimal impurities. In other embodiments, the SrTiO₃ powders may be intentionally modified such as in the case of a doped SrTiO₃ or a reduced SrTiO₃. When a doped SrTiO₃ is used, the dopant can be any suitable dopant, such as one or more of copper (Cu), cobalt (Co), nickel (Ni), chromium (Cr), manganese (Mn), or other transition metal element. When the SrTiO₃ is doped, the doping levels can vary widely, such as from 10 ppm or 100 ppm to 0.1 wt.% of the SrTiO₃ or to 1 wt.% of the SrTiO₃.

In some embodiments, small amounts of a high thermal conductivity filler, such as ceramic boron nitride (BN), may be added to increase thermal conductivity or dielectric breakdown strength of the dielectric material. Exemplary high thermal conductivity filler should also be electrically insulating materials. Increasing the thermal conductivity of the dielectric material may enhance the distribution of heat developed when a device comprising the dielectric material is subjected to high voltages. This in turn could retard or delay dielectric breakdown resulting from thermal stresses. Exemplary high thermal conductivity fillers should have a thermal conductivity greater than 30 W/m·K as determined by ASTM D5470-17, high electrical resistivity of about 10⁶ Ω-cm and about 10¹⁸ Ω-cm at room temperature and under ambient conditions, and high surface area of greater than about 10 m²/g, as measured by ASTM E2980 - 20 standard test method.

Boron nitride (BN) is a thermally conductive ceramic material that is used in various embodiments disclosed herein. BN is commercially available in amorphous (a-BN) and crystalline forms (i.e. hexagonal of hBN - in-plane thermal conductivity of 400 W/m·K and cross plane thermal conductivity of 30 W/m·K and cubic BN - thermal conductivity of 600 W/m·K). In some exemplary embodiments, an exfoliated hBN is used.

Other exemplary high thermal conductivity, electrically insulating fillers include graphene oxide (GO - thermal conductivity ~800 W/m·K) and metal oxides and metal nitrides such as zinc oxide (ZnO - thermal conductivity 50 W/m·K), and aluminum nitride (AlN - thermal conductivity 321 W/m·K). Graphene oxide is a single-layer sheet of graphite oxide and is essentially 2D atomic sheet of graphite containing oxygenated functional groups (such as epoxide, hydroxyl, carbonyl and carboxyl groups) on its basal plane. GO is an electrically insulating material with band gap of 3.5 eV, with high thermal conductivity (~800 W/m·K) and it is also hydrophilic in nature.

In some exemplary embodiments the high thermal conductivity filler consists of boron nitride, aluminum nitride or mixtures thereof.

For example, 1-10 vol.%, preferably 2-8 vol.%, more preferably 3-8 vol.% of high thermal conductivity filler can be added to enhance the dielectric strength (enhanced voltage withstand time and partial discharge values) of the highly loaded insulating polymers described herein.

The high thermal conductivity filler can have a particle size which preferably ranges from about 5 µm to about 40 µm, more preferably from about 10 µm to about 20 µm and having a high surface area (i.e. greater than 10 m²/g. An exemplary boron nitride material can have a high surface area ( >10 m²/g) and a particle size d(0.9) of 10-20 µm as determined by a conventional dynamic light scattering techniques.

Also, additives such as colorants, dispersants (e.g. silane agents) can also be used to improve the dispersion of the ceramic fillers in the polymer matrix.

The dielectric fillers can have a particle size which preferably ranges from about 0.1 µm to about 20 µm, more preferably from about 0.5 µm to about 10 µm. The dielectric fillers are preferably present in the form of a powder. A powder is defined as solid particles having an average diameter of about 10 µm or less.

The dielectric fillers comprise from about 30 vol.% to about 60 vol.% based on the total volume of the dielectric material, preferably from about 45 vol.% to about 55 vol.%, wherein the first dielectric filler comprises from about 20 vol.% to about 45 vol.% based on the total volume of the dielectric material, preferably from about 25 vol.% to about 40 vol.% and wherein the second dielectric filler comprises from about 5 vol.% to about 30 vol.% based on the total volume of the dielectric material, preferably from about 10 vol.% to about 20 vol.%.

In an alternative embodiment, dielectric fillers comprise from about 30 vol.% to about 70 vol.% based on the total volume of the dielectric material, wherein the first dielectric filler comprises from about 20 vol.% to about 55 vol.% based on the total volume of the dielectric material, and wherein the second dielectric filler comprises from about 5 vol.% to about 30 vol.% based on the total volume of the dielectric material.

The dielectric material should have a relative permittivity εᵣ of at least about 4 to provide an adequate capacitance to the primary capacitor. Preferably, the dielectric material has a relative permittivity of between 4 and 10, more preferably of between 4 and 8. Such dielectric material materials are available at reasonable cost and provide for an adequate capacitance of the primary capacitor. Additionally, the dielectric material should have a TCC of +/- 125 ppm, preferably +/- 95 ppm, more preferably less than +/- 50 ppm.

In some embodiments, the dielectric material of the primary capacitor is the same as the insulating polymer material of the plug body. Using the same material to form the dielectric material avoids the use of a second material for the dielectric material, and thereby avoids interfaces between the plug body material and the dielectric material, making the sensored insulation plug more reliable and more cost-effective to manufacture.

The primary capacitor may be the only impedance element of the high voltage portion of the voltage divider. In other words, there may be no other capacitor(s) and no other impedance elements electrically arranged between the elevated voltage and the signal contact of the voltage divider. Independent of the number of capacitors in the voltage divider, the primary capacitor may be the first impedance element in an electrical chain of impedance elements of the voltage divider. In this chain, the primary capacitor may be arranged electrically at the end of the chain and adapted to be electrically connected directly with the elevated voltage. The primary capacitor would thus be the impedance element of the voltage divider which "sees" the full elevated voltage on its input side.

As mentioned previously, the exemplary primary capacitor can be used in the high voltage portion of a voltage divider while the low voltage portion of the voltage divider can comprise one or more low voltage capacitors 141. For elevated voltages of about 50 kV, frequencies of about 50 Hz and target dividing ratios of about 5000, a suitable capacitance of the primary capacitor is in the order of 30 pF. When designing the primary capacitor, further factors like the permittivity of the dielectric material and the geometry of the electrodes should also be considered, as is generally known.

In some embodiments, it may be desirable to keep the TCC of the voltage divide or sensor within a prescribed range. An exemplary voltage divider will comprise the exemplary high voltage capacitor described herein in the high voltage portion of the divider and one or more low voltage capacitors in the low voltage portion. A conventional NPO grade a low voltage capacitor will typically have a TCC of +/-30 ppm/K, so if, for example, a voltage divider is desired that has a total TCC of +/- 125 ppm/K, the high voltage capacitor should have a TCC of less than about 95ppm/K to keep the change in capacitance of the voltage divider within +/- 0.5% from -20°C to 60°C.

In another embodiment, it may be desirable to keep the change in capacitance of a sensor or voltage divide within +/- 0.2% over the temperature range of -20°C to 60°C. Selecting a NPO low voltage capacitor with a TCC of +/-30 ppm/K, means that the high voltage capacitor needs to have a TCC of less than or equal to +/- 20 ppm/k to produce a voltage divider or sensor with a total TCC or less than or equal to +/- 50ppm to achieve the desired 0.2% change in capacitance.

In some embodiments the capacitor and/or sensor is an integral part of a cable- or switchgear accessory, such as a support insulator, a bushing or a basic insulating plug for a separable termination. The casting material has a sufficient electrical withstand to reliably avoid discharges between elements embedded in a typical, common, traditional bushing spaced by a typical distance of a few millimeters or a few centimeters, the elements being on different voltages, such as between an element on "elevated" voltage (HV or MV) and an element on ground. An example of a suitable casting material is the epoxy Epikote 807 and associated curative available from Hexion, (Duisburg, Germany).

Plug body 101 of sensored insulation plug 100 may have a generally rotationally symmetric outer shape. In order to be usable with many existing separable connectors, such as separable connector 10 shown in Fig. 2, the plug body may have a generally frustro-conical outer shape, such that it can fill a frustro-conical rear cavity 70 of the separable connector without leaving a gap between the inner surface of the rear cavity and the outer surface of the plug body. The plug body generally determines the outer shape of the sensored insulation plug.

In some embodiments, plug body can mechanically rigid, have a high dielectric material strength, and/or have minimal variation of its relative permittivity with changes in temperature over the operating temperature range. The material of the plug body should have minimal moisture absorption and should not deteriorate (age) over time. The insulating material may be, for example, a hardened or cured epoxy resin or a hardened or cured mixture of an epoxy resin with other materials, such as fillers, or a hardened or cured polyurethane resin or a hardened or cured mixture of a polyurethane resin with other materials, such as fillers.

Useful fillers are, for example, SiO₂ or Al₂O₃ or other electrically insulating inorganic materials. Alternatively, the insulating material may be or may comprise, for example, a ceramic material.

In some embodiments, plug body 101 can be made of the same dielectric material that is used to form the primary capacitor.

The sensored insulation plug 100 can be inserted into the rear cavity 70 of separable connector 10 by moving it axially into the rear cavity 70 where it can be threadedly engaged with threaded stud 90 - and thereby electrically connected - with the connection element 80 on elevated voltage. The geometry of the sensored insulation plug 100 is adapted to conform to ANSI/IEEE standard 386 (e.g. ANSI/IEEE standard 386-2016, published 14 October 2016) or British Standards Institute (BSI) BS EN50180 (2015). Conformance to an industry standard, although not a requirement for insulation plugs, may generally help obtain compatibility with a greater number of separable connectors.

Sensored insulation plug 100 includes a lug 105 that is fixable connected to and may be partially embedded in plug body 101. The lug includes a protruding portion 106, extending from the plug body 140 and is therefore externally accessible. The protruding portion 06 can have a hexagonal shape, so that torque can be applied to the lug with a wrench. The torque can be transmitted into the entire sensored insulation plug 100, to enable the plug to be threadedly engaged with the threaded stud 90 of the separable connector 10. The expression "partially embedded in the plug body" as used herein refers to being at least partially surrounded by portions of the plug body.

In one embodiment, sensored insulation plug 100 can be formed via a vacuum molding process. The electrodes can be prepositioned in a mold for plug body 101. The exemplary dielectric material can then be added to the mold and cured to form the plug body. When using this manufacturing method, it is important that the viscosity of the uncured dielectric material be low enough to flow into the mold and around the high voltage and measurement electrodes without creating any voids or air gaps. The presence of voids of air gaps may lead to an unwanted partial discharge event when the high voltage electrode is subjected to an elevated voltage.

Where the sensored insulation plug is to be threadedly engaged with the connection element of the separable connector, the insulation plug may have to be turned about its axis for engagement. Thus, the lug may be hexagonally, octagonally, square, or rectangularly shaped, for engagement by a wrench or another tool, so that torque applied by the tool on the insert turns the entire sensored insulation plug. Hence, in certain embodiments, the externally accessible portion of the lug has a polygonal shaped such that external torque can be applied to the sensored insulation plug via the lug.

As mentioned previously, a voltage divider can comprise the exemplary primary capacitor in the high voltage portion and a low voltage portion comprising one or more low-voltage capacitors. The low-voltage capacitors may be disposed within or embedded in the plug body of the sensored insulation plug. Alternatively, the low-voltage capacitor may be arranged external to the sensored insulation plug, such as is described in U.S. Published Patent Appl. No. 2020/0110114A1. It may be remote from the sensored insulation plug. The measurement electrode of the primary capacitor may be electrically connected, or connectable, to the low-voltage capacitor, e.g., by a wire.

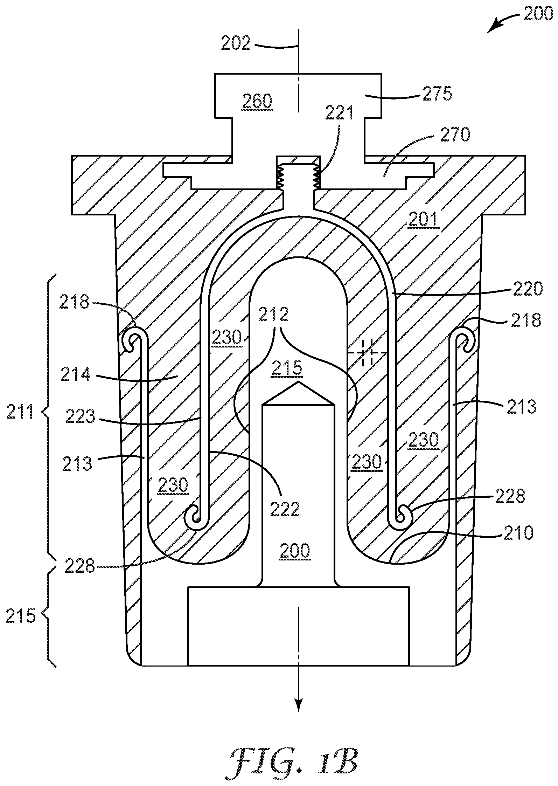

Fig. 1B illustrates a second sensored insulation plug 200 having an exemplary primary capacitor according to an aspect of the invention. Sensored insulation plug 200 is described more fully in EP Appl. No. 201636958. Sensored insulation plug 200 comprises a plug body 201 of an electrically insulating hardened resin and a primary capacitor formed by a high voltage electrode 210 and a measurement or sensing electrode 220, with its dielectric material being formed by a portion 230 of the insulating material of the plug body.

High voltage electrode 210 has an electrode portion 211 and an engagement portion 215 for mechanical engagement and electrical connection with connection element 80 of the separable connector 10 shown in Fig. 2. In use, engagement portion 215 and electrode portion 211 are on the elevated voltage of the connection element 80 of the separable connector 10.

The electrode portion 211 serves as the high voltage electrode 210 of the primary capacitor, which is rotationally symmetric about axis 202. The high voltage electrode 210 has a radially inner portion 212 and a radially outer portion 213 forming a trough 214 between them. The trough 214 is of a generally toroidal shape, due to the rotational symmetry of the sensored insulation plug 200 about a symmetry axis 202. The trough is completely filled with the insulating material of the plug body 201. The trough extends generally for a full 360° perimeter around a central portion 215 of the high voltage electrode 210. In an exemplary aspect, the distal edge 218 of the high voltage electrode 210 is curled radially outwards for electrical stress control at the edge 218.

The "depth" of the trough is determined by the length over which the radially inner portion and the radially outer portion of the high voltage electrode extend axially such that they are generally parallel to one another and facing one another. The deeper the trough, the more space is available to accommodate a larger portion of the measurement electrode within the trough. The larger the portion of the measurement electrode that can be accommodated in the trough, the greater the capacitance of the primary capacitor.

The "width" of the trough as the radial distance between the radially inner portion and the radially outer portion of the high voltage electrode. In general, increasing the width of the trough results in a smaller capacitance of the high voltage capacitor. Thus, a narrower trough is therefore generally preferred where a larger capacitance is desired.

In this exemplary embodiment shown in Fig. 1B, the insulating material that forms the plug body also serves as the dielectric material for the primary capacitor and can have the composition of dielectric material 130 described previously.

The measurement electrode 220 is generally of a bell shape in the depicted embodiment and comprises a threaded support prong 221 which connects the measurement electrode 220 mechanically and electrically with a conductive insert 260. The insert 260 has an embedded portion 270, embedded in the plug body 201, and a protruding portion 275, protruding from the plug body 201 and therefore externally accessible. The protruding portion of the insert 260 can have a hexagonal shape, so that the torque of a wrench can be transmitted into the entire sensored insulation plug 200, which can thereby be threadedly engaged, via a stud (not shown), with the connection element 80 of the separable connector 10. The distal edge 228 of the measurement electrode 220 is curled radially outwards for electrical stress control at the edge 228.

In the embodiment shown in Fig. 1B, the voltage of the measurement electrode 220 can be picked up at the conductive insert 260, and via the insert 260 the primary capacitor can be electrically connected to a low-voltage capacitor, e.g., by a wire, such that the primary capacitor and the low-voltage capacitor form a capacitive voltage divider for sensing the elevated voltage of the connection element 80 of the separable connector 10 into which the sensored insulation plug 200 is inserted.

A lower portion of the measurement or sensing electrode 220 distal from the support prong 221 is arranged in the trough 214 such that it is embedded in the portion 230 of the insulating material of the plug body 201 between the radially inner portion 212 and a radially outer portion 213 of high voltage electrode 210, thus providing that a radially outer surface portion 223 of the sensing electrode 220 facing the radially outer portion 213 of the high voltage electrode 210, and a radially inner surface portion 222 of the sensing electrode 220 facing the radially inner portion 212 of the high voltage electrode 210. This double-facing arrangement increases the overall capacitance of the primary capacitor considerably. In an exemplary aspect, the overall capacitance of the primary capacitor illustrated in Fig. 1B is about 35 pF, while other capacitor geometries were measured to provide capacitances of up to 25 pF only. The higher capacitance of the primary capacitor can reduce the impact of certain unavoidable parasitic capacitances and thereby allows for a higher accuracy in the sensing of the elevated voltage of the separable connector 10.

The toroidal trough-shape of the high voltage electrode and the arrangement of the measurement electrode between two opposed portions of the high voltage electrode maximize the area of overlap between the electrodes and thereby maximize the capacitance of the primary capacitor.

In certain embodiments, the high voltage electrode 210 is generally axially symmetric shape relative to a symmetry axis 202 defining axial and radial directions. The radially inner portion 212 and a radially outer portion 213 of the high voltage electrode 210 are electrically connected with each other and are thus on the same electrical potential and in use, both portions are on elevated voltage.

The measurement electrode of the primary capacitor may be electrically connected, or connectable, to a low-voltage capacitor, such that the primary capacitor and the low-voltage capacitor form a voltage divider for sensing the elevated voltage of a connection element of a separable connector.

The primary capacitor of the sensored insulation plugs described previously are operable as high voltage capacitors in a voltage divider for sensing the elevated voltage. The primary capacitor may be the only impedance element of the high voltage portion of the voltage divider (i.e., there may be no other capacitor(s) and no other impedance elements electrically arranged between the elevated voltage and the signal contact of the voltage divider).

The voltage divider may be a capacitive voltage divider. In other words, both its high voltage portion and its low-voltage portion consist of one or more capacitors, respectively, and are free of other impedance elements, such as resistors or inductances. In other embodiments the voltage divider is a mixed voltage divider, in which the high voltage portion comprises, beyond the primary capacitor, also an inductance or a resistor, and/or in which the low-voltage portion comprises a capacitor, an inductance or a resistor.

The high voltage portion of the voltage divider is the portion that is electrically arranged between a signal contact, at which a divided voltage can be picked up, and the elevated voltage which is to be sensed. The low-voltage portion of the voltage divider is the portion that is electrically arranged between that signal contact and electrical ground.

Independent of the number of capacitors in the voltage divider, the primary capacitor may be the first impedance element in an electrical chain of impedance elements of the voltage divider. In this chain, the primary capacitor may be arranged electrically at the end of the chain and adapted to be electrically connected directly with the elevated voltage. The primary capacitor would thus be the impedance element of the voltage divider which "sees" the full elevated voltage on its input side. This direct electrical connection may be established through the engagement portion of the high voltage electrode and the connection element of the separable connector.

The expressions "directly electrically connected" and "direct electrical connection" as used herein refer to a fully conductive electrical connection between two elements, e.g., via a wire or via a conductive path on a PCB or via a conductive element, without any intermediate electrical component such as a resistor, a capacitor or an inductor, being arranged electrically between the two elements.

The sensored insulation plug according to the present disclosure can be inserted into a separable connector or other electrical connection device or termination designed to accommodate a basic insulating plug to monitor elevated voltage of said device that is part of a power distribution network of a national grid comprising a high voltage and/or medium-voltage power cables that are connected with a separable connector or other connection device. The present disclosure, therefore, provides a separable connector 10 arranged at an end of a medium-voltage power cable 20 wherein the separable connector comprises a connection element 80 for conducting power on elevated voltage, a rear cavity 70 and a sensored insulation plug 100, 200 as described herein, inserted into the rear cavity, wherein the high voltage electrode is electrically connected with the connection element as illustrated in Fig. 2. The separable connector 10 is arranged at an end of a medium-voltage power cable 20 and connects, via a bushing 40, the power-carrying central conductor 50 of the cable 20 to a MV switchgear 30 in a power distribution network of a national grid.

The separable connector 10 of Fig. 2 is a T-shaped separable connector that comprises a front cavity 60 for receiving the bushing 40 connected to switchgear 30, and a rear cavity 70 for receiving an insulation plug of a matching shape. The insulation plug may be a traditional insulation plug without a sensor or a sensored insulation plug 100, 200, according to the present disclosure, shown to the right of the rear cavity 70 in Fig. 2, before being inserted into the rear cavity 70. A traditional insulation plug and a sensored insulation plug 1 according to the present disclosure both serve to electrically insulate a connection element 80 of the separable connector 10, which is electrically connected to the central conductor 50 of the cable 20 and can be electrically and mechanically connected to a conductive component of the bushing 40 via a threaded stud 90. In use, the connection element 80 is on the elevated voltage of the central conductor 50 of the cable.

Various modifications of the primary capacitor and the sensored insulation plug comprising the exemplary primary capacitor of the present invention may be readily apparent to those of skill in the art to which the present invention is directed upon review of the present specification.

### EXAMPLES

Unless otherwise noted, all parts, percentages, ratios, etc. in the Examples and the rest of the specification are by volume.

### Materials

| **Abbreviation** | **Description** |
|---|---|
| SiO₂ | MILLISIL W10 Silicon Dioxide available from Quarzwerke (Frechen, Germany) |
| SiO₂ EST | SILBOND 126EST Epoxysilane Surface Treated Silica available from Quarzwerke (Frechen, Germany). |
| BaTiO₃ | Barium titanate powder, <10µm (CAS Number: 12047-27-7) available from Sigma Aldrich (Darmstadt, Germany). |
| SrTiO₃ | Strontium Titanium Oxide powder, 2µm (CAS Number: 12060-59-2), available from Alfa Aesar (Tewksbury, MA, USA) |
| Al₂O₃ | Martoxid TM 1250 Oxide Ceramic with very high Al₂O₃ content (>99.5%, ) available from Martinswerk GMBH (Bergheim, Germany) |
| MgO | Magnesium oxide (CAS Number: 1333-28-1), available from VWR International GmbH, (Darmstadt, Germany). |
| BN | 3M^{™} Boron Nitride Cooling Fillers (Grade: CFP 007 HS, d(0.9) 10-20 µm) available from (Kempten, Germany) |
| Epoxy | EPIKOTE 807, EPIKURE 866 and Catalyst 03832 (100:80:3) epoxy resin available from Hexion, (Duisburg, Germany). |
| Dispersing agent | Disperse BYK 145 Solvent-free wetting and dispersing additive) available from BYK Chemie (Wesel, Germany) |

### Test Methods

The samples were placed in a climate chamber and cycled from -20°C to +60°C while being energized at 1000 volts primary voltage. A 100nF capacitor placed outside of the climate chamber was used as low voltage portion of the voltage divider. The voltage drop across the 100 nF capacitor was taken as measure for the capacity of the sample.

### Determining Temperature Coefficient of Capacitance (TTC)

The temperature of the climate chamber is then cycled between -20°C and 60°C at a rate of 1°K/min., and at every 5°C a measurement of the secondary voltage and the temperature is recorded by a data logger. TCC is taken as the slope of the capacitance versus temperature and is shown in Table 1.

### Breakdown Voltage

Breakdown voltage was measured according to International Electrotechnical Committee (IEC) test method IEC 60243-1 "Electric Strength of Insulating Materials - Test Methods - Part 1: Tests at Power Frequencies".

### Withstand Voltage

Withstand voltage is measured according to CENELEC) standard HD629.1 S3 depending on the voltage class. Here, the test voltage was 47.5kV for a 30 kV application. The max local field strength is approximately 18 kV/mm with cyclical heating to 60°C (5 hours heating, 3 hours cooling).

### Sample preparation

The epoxy was combined with the filler materials and 0.5 weight percent dispersing agent in a Hauschild V600 speedmixer as prescribed in Table 1. Each sample was mixed at 2350 rpm for 5 minutes at 5 mbar and 60°C until the fillers were homogeneously dispersed in the epoxy matrix material to yield a dielectric material mixture.

Each dielectric material mixture was cast into the test body mold with the high voltage and measurement electrodes were prepositioned in the mold for the test body in a Huebers lab vacuum casting machine. After casting, the dielectric material was crosslinked at 130°C for 1hour under a pressure of 3.5 bar. The test body was the basic insulating plug (BIP) mold with two electrodes, as to create a defined and reproducible electrical field.

**Table 1. Dielectric Material Sample Compositions and Properties**

| Example | Epoxy (Vol. %) | SrTiO₃ (Vol. %) | SiO₂ (Vol. %) | SiO₂ EST (Vol. %) | BaTiO₃ (Vol. %) | Al₂O₃ (Vol. %) | MgO (Vol. %) | BN (Vol. %) | Viscosity at 60°C (mPa·s) | TCC (ppm/K) |
|---|---|---|---|---|---|---|---|---|---|---|
| Ex. 1 | 55 | 10 | 35 | 0 | 0 | 0 | 0 | 0 | <8000 | 90 |
| Ex. 2 | 55 | 15 | 30 | 0 | 0 | 0 | 0 | 0 | <8000 | 30 |
| Ex. 3 | 55 | 20 | 25 | 0 | 0 | 0 | 0 | 0 | <8000 | -20 |
| Ex. 4 | 49 | 16 | 35 | 0 | 0 | 0 | 0 | 0 | <8000 | <10 |
| Ex. 5 | 50 | 12 | 30 | 0 | 0 | 0 | 0 | 8 | <8000 | 110 |
| Ex. 6 | 48 | 12 | 0 | 0 | 0 | 40 | 0 | 0 | <8000 | 80 |
| CE. 1 | 80 | 0 | 0 | 20 | 0 | 0 | 0 | 0 | <8000 | 300 |
| CE. 2 | 70 | 0 | 0 | 30 | 0 | 0 | 0 | 0 | <8000 | 250 |
| CE. 3 | 55 | 0 | 0 | 0 | 0 | 45 | 0 | 0 | >8000 | 260 |
| CE. 4 | 71 | 0 | 0 | 0 | 29 | 0 | 0 | 0 | >8000 | 460 |
| CE. 5 | 55 | 0 | 45 | 0 | 0 | 0 | 0 | 0 | <8000 | 240 |
| CE. 6 | 80 | 0 | 0 | 0 | 0 | 0 | 20 | 0 | >8000 | 300 |
| CE. 7 | 50 | 0 | 30 | 0 | 0 | 0 | 0 | 0 | <8000 | 170 |
| CE. 8 | 68 | 32 | 0 | 0 | 0 | 0 | 0 | 0 | <8000 | -230 |

Dielectric material mixtures with a dynamic viscosity greater than 8000 mPa·s could not be cast into the test body mold. Instead, the dielectric material was poured out onto a metal plate. The dielectric material was squeezed between two metal plates with a spacer of 1 mm to form 1 mm thick sample plate of the dielectric material. After crosslinking, each side of the dielectric material plate was coated to form an electrode so as to form a capacitor. The conductive coating used was a Carbon-conductive Ink (SD 2842 HAL) available from Lackwerke Peters GmbH & Co. KG (Kempen, Germany).

**Table 2. Dielectric Material Sample Compositions and Dielectric Breakdown Strength Properties**

| Example | Epoxy (Vol %) | SrTiO₃ (Vol %) | SiO₂ (Vol %) | Al₂O₃ (Vol %) | BN (Vol %) | TCC (ppm/K) | Breakdown voltage (kV) | Voltage Withstand Time (h at 47.5kV) |
|---|---|---|---|---|---|---|---|---|
| Ex. 2 | 55 | 15 | 30 | 0 | 0 | 30 | >85 | - |
| Ex. 3 | 55 | 20 | 25 | 0 | 0 | -20 | >85 | - |
| Ex. 4 | 49 | 16 | 35 | 0 | 0 | <10 | >85 | - |
| Ex. 5 | 50 | 12 | 30 | 0 | 8 | 110 | >85 | >1000h |
| Ex. 6 | 48 | 12 | 0 | 40 | 0 | 80 | >85 | >1000h |
| CE. 3 | 55 | 0 | 0 | 45 | 0 | 260 | >85 | - |
| CE. 8 | 68 | 32 | 0 | 0 | 0 | -230 | 8 | - |

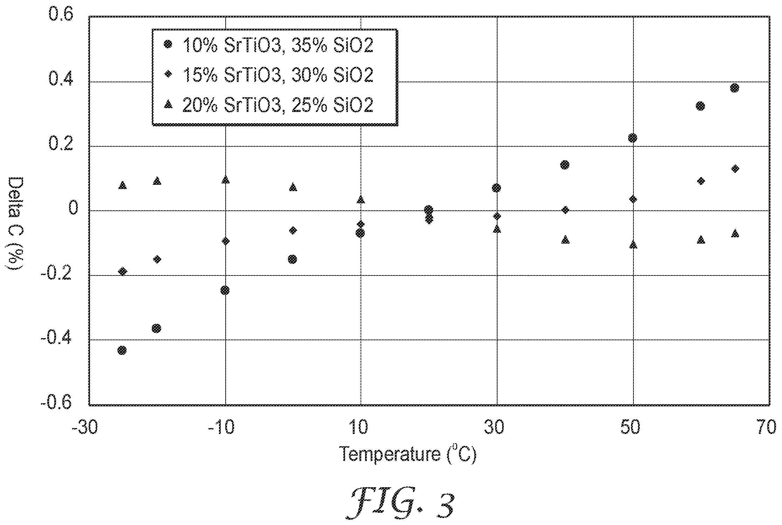

Fig. 3 shows the percent change in capacitance (Delta C) with temperature relative to the capacitance at 25°C of the dielectric material of Examples Ex. 1 - Ex. 3 is less than 0.5% in the use temperature range of the primary capacitor. Samples Ex.2 and Ex. 3 had a percent change in capacitance with temperature that was less than 0.2% in the use temperature range of the primary capacitor.

## Claims

1. A high voltage capacitor for a voltage divider that is configured to sense an elevated voltage for medium and high voltage electrical distribution networks, the high voltage capacitor comprising:
a high voltage electrode (110: 210);
a measurement electrode (120; 220); and
a dielectric material (130; 230) disposed between the high voltage and measurement electrodes, wherein the dielectric material consists of first and second dielectric fillers dispersed in a continuous, insulating polymer matrix, wherein the first dielectric filler comprises one of silicon dioxide and aluminum oxide, wherein the second dielectric filler comprises strontium titanate, wherein in the temperature range of -20°C to 60°C the dielectric material has a change in capacitance in the range from -0.5% to +0.5% and wherein the high voltage capacitor is useable with a line voltage of greater than 6 kV.

2. The capacitor of claim 1, wherein the dielectric material (130; 230) comprises about 40 vol. % to about 75 vol. % insulating polymer matrix, about 20 vol. % to about 45 vol. % first dielectric filler, and about 5 vol. % to about 20 vol. % second dielectric filler.

3. A high voltage capacitor for a voltage divider that is configured to sense an elevated voltage for medium and high voltage electrical distribution networks, the high voltage capacitor comprising:
a high voltage electrode (110: 210);
a measurement electrode (130; 230); and
a dielectric material (130; 230) disposed between the high voltage and measurement electrodes, wherein the dielectric material consists essentially of first and second dielectric fillers and a high thermal conductivity filler dispersed in a continuous, insulating polymer matrix, wherein the first dielectric filler comprises one of silicon dioxide and aluminum oxide, wherein the second dielectric filler comprises strontium titanate, wherein the high thermal conductivity filler has a thermal conductivity greater than 30 W/m·K as determined by ASTM D5470-17, wherein in the temperature range of -20°C to 60°C the dielectric material has a change in capacitance in the range from -0.5% to +0.5%, and wherein the high voltage capacitor is useable with a line voltage of greater than 6 kV.

4. The capacitor of claim 3, wherein the high thermal conductivity filler is electrically insulating.

5. The capacitor of claim 3 or 4, wherein the high thermal conductivity filler consists of boron nitride, aluminum nitride or mixtures thereof.

6. The capacitor of any of claims 3-5, wherein the dielectric material (130; 230) comprises about 40 vol.% to about 75 vol.% insulating polymer matrix, about 20 vol.% to about 45 vol.% first dielectric filler, about 5 vol.% to about 20 vol.% second dielectric filler, and about 1 vol.% to about 10 vol.% high thermal conductivity filler.

7. The capacitor of any of the preceding claims, wherein the dielectric material (130; 230) has a change in capacitance in the range from -0.2% to +0.2% in the temperature range of -20°C to +60°C and has a breakdown voltage greater than 85kV, the breakdown voltage being determined according to International Electrotechnical Committee (IEC) test method IEC 60243-1 "Electric Strength of Insulating Materials - Test Methods - Part 1: "Tests at Power Frequencies".

8. The capacitor of any of the preceding claims, wherein the capacitor withstands a voltage level of 47.5 kV/mm for more than 1000 hours at room temperature.

9. The capacitor of any of the preceding claims, wherein the insulating polymer matrix comprises an epoxy resin matrix.

10. The capacitor of any of the preceding claims, wherein the dielectric material (130; 230) has a temperature coefficient of capacitance that is less than +/- 125 ppm/K as determined according "Determining Temperature Coefficient of Capacitance (TTC)" as set out in the description under "Test Methods".

11. A sensor comprising:
a voltage divider encapsulated in an insulating polymer body,
wherein the voltage divider comprises the high voltage capacitor of any of the preceding claims and a low voltage capacitor connected to the high voltage capacitor in series.

12. The sensor of claim 11, wherein the insulating polymer body consists of the dielectric material (130; 230).

13. A voltage sensing device comprising the high voltage capacitor according to any of claims 1-10.

14. Cable accessory for use with a high and/or medium-voltage power cable in a power network, the accessory comprising the voltage sensing device according to claim 13.

## Patentansprüche

1. Ein Hochspannungskondensator für einen Spannungsteiler, der konfiguriert ist, um eine erhöhte Spannung für elektrische Mittel- und Hochspannungsverteilungsnetze zu erfassen, wobei der Hochspannungskondensator aufweist:
eine Hochspannungselektrode (110; 210);
eine Messelektrode (120; 220); und
ein dielektrisches Material (130; 230), das zwischen den Hochspannungs- und Messelektroden angeordnet ist, wobei das dielektrische Material aus ersten und zweiten dielektrischen Füllstoffen besteht, die in einer kontinuierlichen, isolierenden Polymermatrix dispergiert sind, wobei der erste dielektrische Füllstoff eines von Siliciumdioxid und Aluminiumoxid aufweist, wobei der zweite dielektrische Füllstoff Strontiumtitanat aufweist, wobei in dem Temperaturbereich von -20 °C bis 60 °C das dielektrische Material eine Kapazitätsänderung in dem Bereich von -0,5 % bis +0,5 % aufweist und wobei der Hochspannungskondensator mit einer Leitungsspannung von größer als 6 kV verwendbar ist.

2. Der Kondensator nach Anspruch 1, wobei das dielektrische Material (130; 230) zu etwa 40 Vol.-% bis etwa 75 Vol.-% isolierende Polymermatrix, zu etwa 20 Vol.-% bis etwa 45 Vol.-% ersten dielektrischen Füllstoff und zu etwa 5 Vol.-% bis etwa 20 Vol.-% zweiten dielektrischen Füllstoff aufweist.

3. Ein Hochspannungskondensator für einen Spannungsteiler, der konfiguriert ist, um eine erhöhte Spannung für elektrische Mittel- und Hochspannungsverteilungsnetze zu erfassen, wobei der Hochspannungskondensator aufweist:
eine Hochspannungselektrode (110; 210);
eine Messelektrode (130; 230); und
ein dielektrisches Material (130; 230), das zwischen den Hochspannungs- und Messelektroden angeordnet ist, wobei das dielektrische Material im Wesentlichen aus ersten und zweiten dielektrischen Füllstoffen und einem Füllstoff mit hoher Wärmeleitfähigkeit besteht, die in einer kontinuierlichen, isolierenden Polymermatrix dispergiert sind, wobei der erste dielektrische Füllstoff eines von Siliciumdioxid und Aluminiumoxid aufweist, wobei der zweite dielektrische Füllstoff Strontiumtitanat aufweist, wobei der Füllstoff mit hoher Wärmeleitfähigkeit eine Wärmeleitfähigkeit größer als 30 W/m·K aufweist, wie durch ASTM D5470-17 bestimmt, wobei in dem Temperaturbereich von -20 °C bis 60 °C das dielektrische Material eine Kapazitätsänderung in dem Bereich von -0,5 % bis +0,5 % aufweist, und wobei der Hochspannungskondensator mit einer Netzspannung größer als 6 kV verwendbar ist.

4. Der Kondensator nach Anspruch 3, wobei der Füllstoff mit hoher Wärmeleitfähigkeit elektrisch isolierend ist.

5. Der Kondensator nach Anspruch 3 oder 4, wobei der Füllstoff mit hoher Wärmeleitfähigkeit aus Bornitrid, Aluminiumnitrid oder Mischungen davon besteht.

6. Der Kondensator nach einem der Ansprüche 3 bis 5, wobei das dielektrische Material (130; 230) zu etwa 40 Vol.-% bis etwa 75 Vol.-% isolierende Polymermatrix, zu etwa 20 Vol.-% bis etwa 45 Vol.-% ersten dielektrischen Füllstoff, zu etwa 5 Vol.-% bis etwa 20 Vol.-% zweiten dielektrischen Füllstoff und zu etwa 1 Vol.-% bis etwa 10 Vol.-% Füllstoff mit hoher Wärmeleitfähigkeit aufweist.

7. Der Kondensator nach einem der vorstehenden Ansprüche, wobei das dielektrische Material (130; 230) eine Kapazitätsänderung in dem Bereich von -0,2 % bis +0,2 % in dem Temperaturbereich von -20 °C bis +60 °C aufweist und eine Durchschlagspannung größer als 85 kV hat, wobei die Durchschlagspannung gemäß dem Prüfverfahren IEC 60243-1 "Electric Strength of Insulating Materials - Test Methods - Part 1: "Tests at Power Frequencies"" des International Electrotechnical Committee (IEC) bestimmt wird.

8. Der Kondensator nach einem der vorstehenden Ansprüche, wobei der Kondensator einem Spannungspegel von 47,5 kV/mm für mehr als 1000 Stunden bei Raumtemperatur standhält.

9. Der Kondensator nach einem der vorstehenden Ansprüche, wobei die isolierende Polymermatrix eine Epoxidharzmatrix aufweist.

10. Der Kondensator nach einem der vorstehenden Ansprüche, wobei das dielektrische Material (130; 230) einen Temperaturkoeffizienten der Kapazität aufweist, der kleiner als +/- 125 ppm/K ist, wie gemäß "Determining Temperature Coefficient of Capacitance (TTC)" bestimmt, wie in der Beschreibung unter "Test Methods" dargelegt.

11. Ein Sensor, aufweisend:
einen Spannungsteiler, der in einem isolierenden Polymerkörper eingekapselt ist, wobei der Spannungsteiler den Hochspannungskondensator nach einem der vorstehenden Ansprüche und einen Niederspannungskondensator aufweist, der mit dem Hochspannungskondensator in Reihe geschaltet ist.

12. Der Sensor nach Anspruch 11, wobei der isolierende Polymerkörper aus dem dielektrischen Material (130; 230) besteht.

13. Eine Spannungserfassungsvorrichtung, die den Hochspannungskondensator nach einem der Ansprüche 1 bis 10 aufweist.

14. Kabelzubehör zur Verwendung mit einem Hoch- und/oder Mittelspannungskabel in einem Stromnetz, wobei das Zubehör eine Spannungserfassungsvorrichtung nach Anspruch 13 aufweist.

## Revendications

1. Condensateur haute tension pour un diviseur de tension qui est configuré pour capter une tension élevée pour des réseaux de distribution électriques moyenne et haute tension, le condensateur haute tension comprenant :
une électrode haute tension (110 : 210) ;
une électrode de mesure (120 ; 220) ; et
un matériau diélectrique (130 ; 230) disposé entre les électrodes haute tension et de mesure, dans lequel le matériau diélectrique est constitué de première et seconde charges diélectriques dispersées dans une matrice polymère isolante continue, dans lequel la première charge diélectrique comprend l'un parmi du dioxyde de silicium et de l'oxyde d'aluminium, dans lequel la seconde charge diélectrique comprend du titanate de strontium, dans lequel, dans la plage de températures allant de -20 °C à 60 °C, le matériau diélectrique présente une variation de capacité dans la plage allant de -0,5 % à +0,5 %, et dans lequel le condensateur haute tension peut être utilisé avec une tension secteur supérieure à 6 kV.

2. Condensateur selon la revendication 1, dans lequel le matériau diélectrique (130 ; 230) comprend environ 40 % en volume à environ 75 % en volume de matrice polymère isolante, environ 20 % en volume à environ 45 % en volume de première charge diélectrique, et environ 5 % en volume à environ 20 % en volume de seconde charge diélectrique.

3. Condensateur haute tension pour un diviseur de tension qui est configuré pour capter une tension élevée pour des réseaux de distribution électriques moyenne et haute tension, le condensateur haute tension comprenant :
une électrode haute tension (110 : 210) ;
une électrode de mesure (130 ; 230) ; et
un matériau diélectrique (130 ; 230) disposé entre les électrodes haute tension et de mesure, dans lequel le matériau diélectrique est essentiellement constitué de première et seconde charges diélectriques et d'une charge à haute conductivité thermique dispersée dans une matrice polymère isolante continue, dans lequel la première charge diélectrique comprend l'un parmi du dioxyde de silicium et de l'oxyde d'aluminium, dans lequel la seconde charge diélectrique comprend du titanate de strontium, dans lequel la charge à haute conductivité thermique a une conductivité thermique supérieure à 30 W/m·K, tel que déterminé par la norme ASTM D5470-17, dans lequel, dans la plage de température de - 20 °C à 60 °C, le matériau diélectrique présente une variation de capacité comprise entre -0,5 % et +0,5 %, et dans lequel le condensateur haute tension peut être utilisé avec une tension secteur supérieure à 6 kV.

4. Condensateur selon la revendication 3, dans lequel la charge à haute conductivité thermique est électriquement isolante.

5. Condensateur selon la revendication 3 ou 4, dans lequel la charge à haute conductivité thermique est constituée de nitrure de bore, de nitrure d'aluminium ou de mélanges de ceux-ci.

6. Condensateur selon l'une quelconque des revendications 3 à 5, dans lequel le matériau diélectrique (130 ; 230) comprend environ 40 % en volume à environ 75 % en volume de matrice de polymère isolante, environ 20 % en volume à environ 45 % en volume de première charge diélectrique, environ 5 % en volume à environ 20 % en volume de seconde charge diélectrique, et environ 1 % en volume à environ 10 % en volume de charge à haute conductivité thermique.

7. Condensateur selon l'une quelconque des revendications précédentes, dans lequel le matériau diélectrique (130 ; 230) présente une variation de capacité dans la plage allant de -0,2 % à +0,2 % dans la plage de températures de -20 °C à +60 °C et a une tension de claquage supérieure à 85 kV, la tension de claquage étant déterminée conformément à la méthode d'essai du Comité électrotechnique international (CEI) CEI 60243-1 « Résistance électrique des matériaux isolants - Méthodes d'essai - Partie 1 : « Essais aux fréquences industrielles ».

8. Condensateur selon l'une quelconque des revendications précédentes, dans lequel le condensateur résiste à un niveau de tension de 47,5 kV/mm pendant plus de 1000 heures à température ambiante.

9. Condensateur selon l'une quelconque des revendications précédentes, dans lequel la matrice polymère isolante comprend une matrice de résine époxy.

10. Condensateur selon l'une quelconque des revendications précédentes, dans lequel le matériau diélectrique (130 ; 230) a un coefficient de température de capacité qui est inférieur à +/- 125 ppm/K, tel que déterminé selon la « Détermination du coefficient de température de capacité (TTC) », comme indiqué dans la description sous « Méthodes d'essai ».

11. Capteur comprenant :
un diviseur de tension encapsulé dans un corps polymère isolant,
dans lequel le diviseur de tension comprend le condensateur haute tension selon l'une quelconque des revendications précédentes et un condensateur basse tension connecté au condensateur haute tension en série.

12. Capteur selon la revendication 11, dans lequel le corps polymère isolant est constitué du matériau diélectrique (130 ; 230).

13. Dispositif de détection de tension comprenant le condensateur haute tension selon l'une quelconque des revendications 1 à 10.

14. Accessoire de câble destiné à être utilisé avec un câble d'alimentation haute et/ou moyenne tension dans un réseau électrique, l'accessoire comprenant le dispositif de détection de tension selon la revendication 13.
